# EUROPEAN PATENT APPLICATION

(11) **EP 4 746 590 A1**
(43) Date of publication of application: **20.05.2026**
(21) Application number: 25206338.3
(22) Date of filing: 02.10.2025
(51) Int. Cl.: H05K 1/11

(54) **VERTICAL INTERCONNECTS FOR DEVICE MINIATURIZATION**

(30) Priority: 15.11.2024 US 202418948573
(71) Applicant: INTEL Corporation, Santa Clara, CA 95054 (US)
(72) Inventor: CHEAH, Bok Eng, 07 11700 Gelugor (MY); KONG, Jackson Chung Peng, 10470 Tanjung Tokong, Penang (MY); KUAN, Chin Lee, 28700 Bentong, Pahang (MY); LIM, Seok Ling, 14000 Bukit Mertajam, Penang (MY); ONG, Jenny Shio Yin, 07 11900 Bayan Lepas (MY)
(74) Representative: Viering, Jentschura & Partner mbB Patent- und Rechtsanwälte

(57) **Abstract**

An electronic assembly is provided, including a substrate having a first surface and an opposing second surface; a first interconnect in the substrate extending perpendicular to the first surface and the second surface; a second interconnect in the substrate extending perpendicular to the first surface and the second surface; a third interconnect arranged between the first interconnect and the second interconnect; a first contact pad having a first recessed side and coupled to a first terminal of the first interconnect; a subsequent first contact pad having a subsequent first recessed side and coupled to an opposing second terminal of the first interconnect; a second contact pad having a second recessed side and coupled to a first terminal of the second interconnect, and a subsequent second contact pad having a subsequent second recessed side and coupled to an opposing second terminal of the second interconnect.

## Description

### Background

Vertical interconnects, e.g., plated through hole (PTH), in package and/or printed circuit board (PCB) is an important aspect to preserve signal and power integrity (SI/PI) performance. Specifically, for signal integrity, an optimal signal-to-ground (S:G) ratio is critical to enable next-generation high-speed Input/Output (I/O), such as Thunderbolt^{™} 5th Generation (TBT 5) with operating data-rate (80 to 120 Gbps), PCIe6 (64 Gbps) as well as memory (e.g., double data-rate (DDR) or low-power double data-rate (LPDDR)) beyond 10GT/s. A number of vertical ground (Vss) interconnects are required in the vicinity of high-speed data signals to meet the bin speed target for advanced applications. Adequate Vss referencing in the vertical transition helps to mitigate crosstalk noises, thus ensuring robust system margin.

Current solutions to address SI/PI performance bottlenecks include increasing the number of Vss PTH interconnects (i.e., lower S:G Ratio). In addition, physical dimension scaling of the vertical interconnect is pursued with reduced contact pad geometry or PTH drill size, e.g., drill bit diameter reduction from 10 mils to 6 mils, for improved interconnect density or minimizing the real-estate trade-off due to additional Vss PTHs for noise shielding.

The disadvantages of the abovementioned solutions may include hindrance to package and/or platform miniaturization initiative, manufacturing costs trade-off, i.e., increased frequency of mechanical drill bit replacement with reduced bit diameter and increased assembly yield losses due to more stringent screening of parts meeting the desired specifications.

### Brief Description of the Drawings

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1A shows a top view of an electronic assembly according to an aspect of the present disclosure.
FIG. 1B shows a cross-sectional view of the electronic assembly according to the aspect as shown in FIG. 1A.
FIG. 1C illustrates design parameters of vertical interconnects in the top view according to the aspect shown in FIG. 1A to achieve robust manufacturability according to an aspect of the present disclosure.
FIG. 2 shows a cross-sectional view of an electronic assembly according to another aspect of the present disclosure.
FIG. 3 shows a flowchart illustrating a method of forming an electronic assembly according to an aspect of the present disclosure.
FIGS. 4A through 4H show views directed to an exemplary process flow for a method of forming an electronic assembly according to an aspect of the present disclosure.
FIGS. 5A through 5F show views directed to an exemplary process flow for a method of forming an electronic assembly according to an aspect of the present disclosure.
FIG. 6 shows an illustration of a computing device that includes an electronic assembly according to a further aspect of the present disclosure.

### Detailed Description

The following detailed description refers to the accompanying drawings that show, by way of illustration, specific details and aspects in which the present disclosure may be practiced. These aspects are described in sufficient detail to enable those skilled in the art to practice the present disclosure. Various aspects are provided for devices, and various aspects are provided for methods. It will be understood that the basic properties of the devices also hold for the methods and vice versa. Other aspects may be utilized and structural, and logical changes may be made without departing from the scope of the present disclosure. The various aspects are not necessarily mutually exclusive, as some aspects can be combined with one or more other aspects to form new aspects.

The present disclosure addresses the device form-factor miniaturization for high performance computing applications. The present disclosure also addresses power delivery impairment due to extensive loop inductance.

In all aspects, the present disclosure generally relates to an electronic assembly that may include a substrate having a first surface and a second surface opposite the first surface, a first interconnect in the substrate extending perpendicular to the first surface and the second surface, a second interconnect in the substrate extending perpendicular to the first surface and the second surface, and a third interconnect arranged between the first interconnect and the second interconnect. The electronic assembly may include a first contact pad having a first recessed side and coupled to a first terminal of the first interconnect, and may include a subsequent first contact pad having a subsequent first recessed side and coupled to an opposing second terminal of the first interconnect. The electronic assembly may include a second contact pad having a second recessed side and coupled to a first terminal of the second interconnect, and may include a subsequent second contact pad having a subsequent second recessed side and coupled to an opposing second terminal of the second interconnect.

The present disclosure further generally relates to a computing device. The computing device may include a printed circuit board, and an electronic assembly coupled to the printed circuit board. The electronic assembly may include a substrate having a first surface and a second surface opposite the first surface, a first interconnect in the substrate extending perpendicular to the first surface and the second surface, a second interconnect in the substrate extending perpendicular to the first surface and the second surface, and a third interconnect arranged between the first interconnect and the second interconnect. The electronic assembly may include a first contact pad having a first recessed side and coupled to a first terminal of the first interconnect, and may include a subsequent first contact pad having a subsequent first recessed side and coupled to an opposing second terminal of the first interconnect. The electronic assembly may include a second contact pad having a second recessed side and coupled to a first terminal of the second interconnect, and may include a subsequent second contact pad having a subsequent second recessed side and coupled to an opposing second terminal of the second interconnect.

The present disclosure generally relates to a method of forming an electronic assembly. The method may include providing a substrate with a first surface and a second surface opposite the first surface; forming a first interconnect in the substrate, the first interconnect extending perpendicular to the first surface and the second surface; forming a second interconnect in the substrate, the second interconnect extending perpendicular to the first surface and the second surface; and forming a third interconnect between the first interconnect and the second interconnect. The method may further include forming a first contact pad having a first recessed side and coupled to a first terminal of the first interconnect, and forming a subsequent first contact pad having a subsequent first recessed side and coupled to an opposing second terminal of the first interconnect. The method may further include forming a second contact pad having a second recessed side and coupled to a first terminal of the second interconnect, and forming a subsequent second contact pad having a subsequent second recessed side and coupled to an opposing second terminal of the second interconnect.

Advantages of the present disclosure may include device (package and/or printed circuit board) miniaturization through reduced pitch geometry of plated through hole (PTH) vertical interconnects. According to the present disclosure, approximately 25% package and/or board real-estate savings and/or z-height reduction (e.g., through reduced signal redistribution layers) may be achievable through improved routing density.

Further advantages of the present disclosure may include improved electrical (signal and/or power integrity) performance through tighter signal to ground coupling, i.e., improved signal current return path (for single-ended bus, e.g., double data-rate (DDR) memory interface) and tighter differential signal coupling, e.g., a universal serial bus (USB) Interface, a peripheral component interconnect express (PCIe) interface for reduced crosstalk to adjacent differential pairs. Tighter power (Vcc) to ground (Vss) interconnect coupling reduces alternating current (AC) loop inductance for improved power supply delivery or power integrity.

To more readily understand and put into practice the aspects of the present disclosure, particular aspects will now be described by way of examples and not limitations, and with reference to the figures. For the sake of brevity, duplicate descriptions of features and properties may be omitted.

It should be understood that the terms "on", "under", "top", "bottom", etc., when used in this description are used for convenience and to aid understanding of relative positions or directions, and not intended to limit the orientation of any device, or structure or any part of any device or structure.

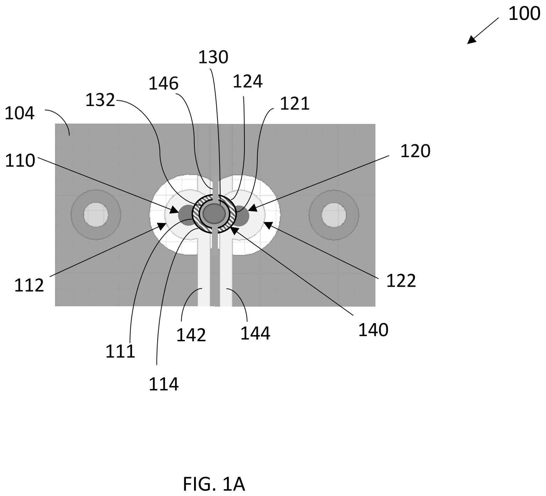

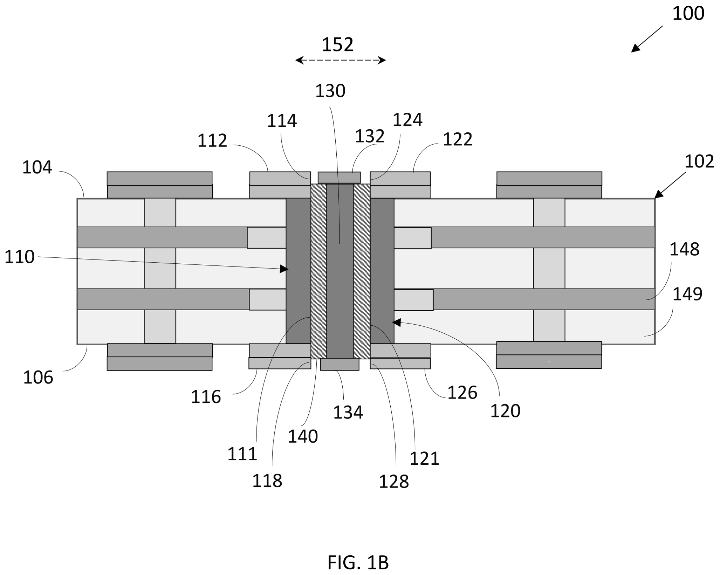

FIG. 1A shows a top view of in an electronic assembly 100 for improved electrical performance and device miniaturization according to an aspect of the present disclosure. FIG. 1B shows a cross-sectional view of the electronic assembly 100 according to the aspect as shown in FIG. 1A.

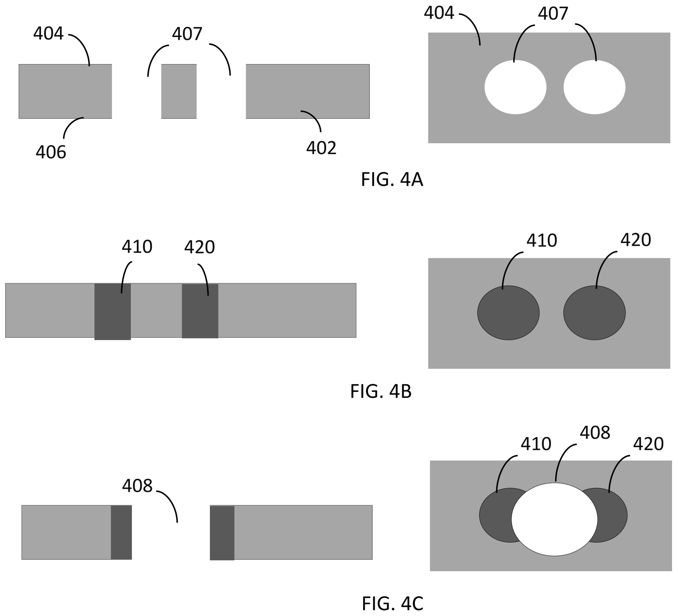

In various aspects, the electronic assembly 100 may include a substrate 102 having a first surface 104 and a second surface 106 opposite the first surface 104. The first surface 104 may be a top surface of the substrate 102. The second surface 106 may be a bottom surface of the substrate 102. The first surface 104 and the second surface 106 may be substantially horizontal when viewed from a cross-sectional viewpoint. In an aspect as shown in FIG. 1B, the substrate 102 may include a printed circuit board, which may include a stack of alternating metal layers 148 and dielectric layers 149. In another aspect (e.g., as shown in FIGS. 4A-4H below), the substrate 102 may include a silicon or glass substrate, or a package substrate, e.g., an organic or ceramic substrate. In various aspects, the substrate 102 may be coupled to a further printed circuit board, e.g., arranged on the further printed circuit board.

In various aspects, the electronic assembly 100 may include a first interconnect 110 in the substrate 102, wherein the first interconnect 110 may extend perpendicular to the first surface 104 and the second surface 106. In other words, the first interconnect 110 may extend vertically across the thickness of the substrate 102 to form a first vertical interconnect 110, for example, a plated through hole (PTH).

In various aspects, the electronic assembly 100 may include a second interconnect 120 in the substrate 102, wherein the second interconnect 120 may extend perpendicular to the first surface 104 and the second surface 106. In other words, the second interconnect 120 may extend vertically across the thickness of the substrate 102 to form a second vertical interconnect 120, for example, a PTH.

In various aspects, the electronic assembly 100 may include a third interconnect 130 arranged between the first interconnect 110 and the second interconnect 120. In various aspects, the third interconnect 130 may extend in parallel with the first interconnect 110 and the second interconnect 120. In other words, the third interconnect 130 may extend perpendicular to the first surface 104 and the second surface 106 to form a third vertical interconnect 130, for example, a PTH.

In various aspects, the electronic assembly 100 may further include a first contact pad 112 coupled to a first terminal of the first interconnect 110 at the first surface 104. The first contact pad 112 may include a first recessed side 114. The first contact pad 112 may be arranged at least partially on the first surface 104 of the substrate 102.

The first recessed side 114 of the first contact pad 112 may include a receding portion that cuts inwards. In various aspects, the first contact pad 112 may include a receding portion having a cross section in a crescent and/or gibbous shape, e.g., as shown in FIG. 1A. Other shapes may also be possible.

In various aspects, the electronic assembly 100 may further include a subsequent first contact pad 116 coupled to an opposing second terminal of the first interconnect 110 at the second surface 106. The subsequent first contact pad 116 may include a subsequent first recessed side 118. The subsequent first contact pad 116 may be arranged at least partially on the second surface 106 of the substrate 102.

The subsequent first recessed side 118 of the subsequent first contact pad 116 may include a receding portion that cuts inwards. In various aspects, the subsequent first contact pad 116 may include a receding portion having a cross section in a crescent and/or gibbous shape. Other shapes may also be possible.

In various aspects, the electronic assembly 100 may further include a second contact pad 122 coupled to a first terminal of the second interconnect 120 at the first surface 104. The second contact pad 122 may include a second recessed side 124. The second contact pad 122 may be arranged at least partially on the first surface 104 of the substrate 102.

The second recessed side 124 of the second contact pad 122 may include a receding portion that cuts inwards. In various aspects, the second contact pad 122 may include a receding portion having a cross section in a crescent and/or gibbous shape. Other shapes may also be possible.

In various aspects, the electronic assembly 100 may further include a subsequent second contact pad 126 coupled to an opposing second terminal of the second interconnect 120 at the second surface 106. The subsequent second contact pad 126 may include a subsequent second recessed side 128. The subsequent second contact pad 126 may be arranged at least partially on the second surface 106 of the substrate 102.

The subsequent second recessed side 128 of the subsequent second contact pad 126 may include a receding portion that cuts inwards. In various aspects, the subsequent second contact pad 126 may include a receding portion having a cross section in a crescent and/or gibbous shape. Other shapes may also be possible.

In various aspects, the electronic assembly 100 may further include a third contact pad 132 coupled to a first terminal of the third interconnect 130 at the first surface 104, and a subsequent third contact pad 134 coupled to an opposing second terminal of the third interconnect 130 at the second surface 106. In an aspect, the third contact pad 132 may be arranged on the first surface 104, and the subsequent third contact pad 134 may be arranged under the second surface 106.

The third contact pad 132 may be at least partially encircled by the first recessed side 114 and the second recessed side 124. The subsequent third contact pad 134 may be at least partially encircled by the subsequent first recessed side 118 and the subsequent second recessed side 128. The third contact pad 132 and the subsequent third contact pad 134 may have a circular shape, or any other suitable shape.

In various aspects, the first recessed side 114 and the second recessed side 124 may face a side of the third contact pad 132. The subsequent first recessed side 118 and the subsequent second recessed side 128 may face a side of the subsequent third contact pad 134.

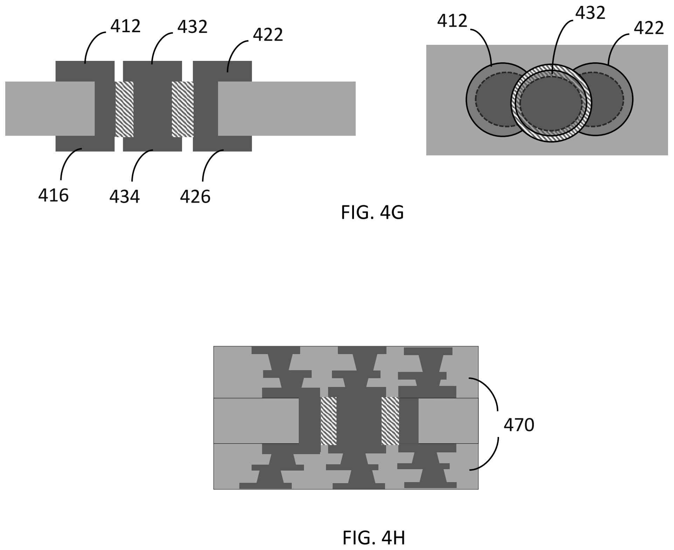

In an aspect, the first contact pad 112, the second contact pad 114, the subsequent first contact pad 116 and the subsequent second contact pad 126 may include one or more layers or may include an integral layer, and may have a thickness larger than a thickness of the third contact pad 132 and the subsequent third contact pad 134, as shown in FIG. 1B. In another aspect, the first contact pad 112, the second contact pad 114, the subsequent first contact pad 116 and the subsequent second contact pad 126 may have a same thickness with the third contact pad 132 and the subsequent third contact pad 134, as shown in FIG. 4G below.

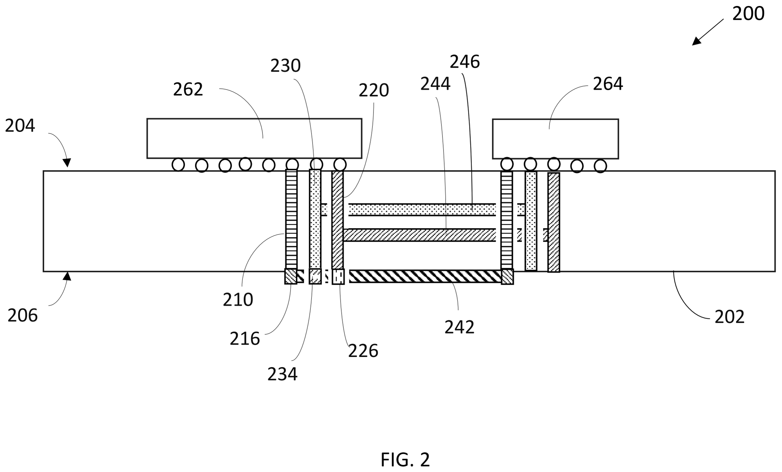

In an aspect, the third interconnect 130 may have a height or depth larger than the first interconnect 110 and the second interconnect 120, as shown in FIG. 1B. In another aspect, the third interconnect 130 may have a height or depth same with the first interconnect 110 and the second interconnect 120, as shown in FIG. 2 and FIG. 4G below.

In various aspects, the third interconnect 130 may be isolated from the first interconnect 110 and the second interconnect 120 by a dielectric layer 140. The dielectric layer 140 may include epoxy polymer, polyimide, polyamide, or polyethylene, for example.

The distance between the centers of the first interconnect 110 and the second interconnect 120 may be defined as a pitch 152. According to an aspect, the pitch 152 may be equal to or less than 260µm. According to various aspects, the pitch 152 may be 250µm, 300µm, 350µm, 400µm, 450µm, or 500µm according to design choices. In further aspects, the pitch 152 may be in a range of 100µm - 600µm, e.g., in a range of 100µm - 260µm, e.g., in a range of 100µm - 240µm, e.g., in a range of 100µm - 190µm, e.g., in a range of 100µm-150µm. It is to be understood that the pitch dimensions may not be limited to the above exemplary dimensions or ranges, and may be scaled according to the scope of implementation, manufacturing technologies and/or design choices. In an example, the pitch may be about 240µm for a package level implementation, and may be in a range of 300µm - 600µm for a motherboard level implementation.

Based on various aspects of the present disclosure, the third interconnect 130 may be additionally provided within the pitch dimension of the first interconnect 110 and the second interconnect 120, as compared to conventional structures wherein two interconnects may be provided in the same pitch dimension required according to the design rules. In an exemplary design with a pitch of 260µm, the interconnect structure according to the aspects of FIG. 1A and FIG. 1B may occupy a total length of 1560µm for transmission of every 8 signals, as compared to conventional interconnect structures which may occupy a total length of 2080µm for transmission of every 8 signals, thereby achieving approximately 25% real estate saving.

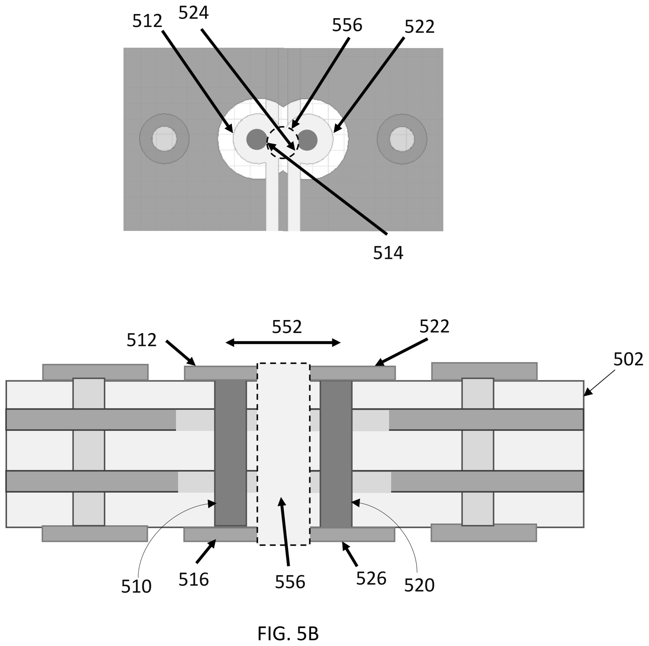

In various aspects, the first interconnect 110 may include a first side wall 111 having a height extending between the first surface 104 and the second surface 106 of the substrate 102. In an aspect, the first side wall 111 may include a recessed portion that may extend between the first surface 104 and the second surface 106 to form a first recessed side wall 111. In the aspect shown in FIG. 1A, the first recessed side wall 111 of the first interconnect 110 may have a crescent-shaped cross section. In another aspect as shown in FIG. 5B below, the first side wall 111 may be integral without a recessed portion, similar to a side wall of a cylinder.

In an aspect, the first recessed side 114 of the first contact pad 112 and the subsequent first recessed side 118 of the subsequent first contact pad 116 may be aligned with the first recessed side wall 111 of the first interconnect 110. In other words, the respective receding portion of the first recessed side 114 and the first recessed side wall 111 may coincide at the first surface 104, and the respective receding portion of the subsequent first recessed side 118 and the first recessed side wall 111 may coincide at the second surface 106.

Conveniently though not necessarily, the first recessed side wall 111 may have the same shape with the first and the subsequent first recessed sides 114, 118, e.g., a crescent shape as shown in FIG. 1A and FIG. 1B.

In various aspects, the second interconnect 120 may include a second side wall 121 having a height extending between the first surface 104 and the second surface 106 of the substrate 102. In an aspect, the second side wall 121 may include a recessed portion that may extend between the first surface 104 and the second surface 106 to form a second recessed side wall 121. In the aspect shown in FIG. 1A, the second recessed side wall 121 of the second interconnect 120 may have a crescent-shaped cross section. In another aspect as shown in FIG. 5B below, the second side wall 121 may be integral without a recessed portion, similar to a side wall of a cylinder.

In an aspect, the second recessed side 124 of the second contact pad 122 and the subsequent second recessed side 128 of the subsequent second contact pad 126 may be aligned with the second recessed side wall 121 of the second interconnect 120. In other words, the respective receding portion of the second recessed side 124 and the second recessed side wall 121 may coincide at the first surface 104 and the respective receding portion of the subsequent second recessed side 128 and the second recessed side wall 121 may coincide at the second surface 106.

Conveniently though not necessarily, the second recessed side wall 121 may have the same shape with the second and the subsequent second recessed sides 124, 128, e.g., a crescent shape as shown in FIG. 1A and FIG. 1B.

In various aspects, the third interconnect 130 may extend in parallel with and may be at least partially encircled by the first recessed side wall 111 and the second recessed side wall 121. In various aspects, the first recessed side wall 111 and the second recessed side wall 121 may face the third interconnect 130.

In an aspect, the first interconnect 110, the second interconnect 120, and the third interconnect 130 may be configured to facilitate electrical signal transmission.

In one aspect, the first interconnect 110 and the second interconnect 120 may be configured to transmit a single-ended bus signal, e.g., a low-power double data-rate (LPDDR) memory interface at 8533 MT/s or beyond. In another aspect, the first interconnect 110 and the second interconnect 120 may be configured to transmit a differential-pair bus signal, e.g., a universal serial bus Gen4 (USB4.0) interface operating at ≥20Gbps, a Thunderbolt^{™} 5th Generation (TBT 5) interface with operating data-rate ranging from 80 to 120 Gbps, a peripheral component interconnect express Gen6 PCIe6 (64 Gbps), or a serial-de-serializer (Serdes) ethernet interface operating at ≥112Gbps. The third interconnect 130 may be coupled to a reference voltage, e.g., a ground (Vss) reference voltage, for noise shielding through a shorter current return path.

In a further aspect, the first interconnect 110, the second interconnect 120, and the third interconnect 130 may be configured to facilitate power delivery. In an aspect, the first interconnect 110 and the second interconnect 120 may be configured with a voltage supply, e.g., a 1.0 V supply. In another aspect, the first interconnect 110 may be configured with a first voltage supply, e.g., a 1.0V supply, and the second interconnect 120 may be configured with a second voltage supply different from the first voltage supply, e.g., a 1.5V supply. The third interconnect 130 may be configured to a reference voltage, such as a ground (Vss) reference voltage for improved power integrity through a reduced AC inductance loop.

In various aspects, the electronic assembly 100 may optionally include one or more first metal traces and/or planes 142 coupled to the first interconnect 110 and/or one or more of the first and the subsequent first contact pads 112, 116, e.g., as shown in the aspect of FIG. 1A. In further aspects, the electronic assembly 100 may optionally include one or more second metal traces and/or planes 144 coupled to the second interconnect 120 and/or one or more of the second and the subsequent second contact pads 122, 126. In further aspects, the electronic assembly 100 may optionally include one or more third metal traces and/or planes 146 coupled to the third interconnect 130 and/or one or more of the third and the subsequent third contact pads 132, 134.

In various aspects, each of the first, the second and the third metal traces 142, 144, 146 may be arranged on the first surface 104 or the second surface 106, or may be embedded within the substrate 102.

In an aspect, the metal traces 142, 144, 146 may be included for signal/power breakouts when there is no direct vertical alignment from a first device (e.g., coupled to the first terminals of the interconnects 110, 120, 130) to a base of package/PCB or a first component (e.g., coupled to the second terminals of the interconnects 110, 120, 130).

In another aspect, the electronic assembly 100 may exclude the metal traces 142, 144, 146 for power integrity connections wherein the interconnects 110, 120, 130 may be used as vertical transition current paths connecting to top-layer substrate vias (e.g., landed beneath device bumps at the first surface 104) and bottom-layer substrate vias (e.g., connected to a base of package/PCB, i.e. solder balls, socket pins, or capacitors).

In various aspects, the first terminal of the first interconnect 110 and the first terminal of the second interconnect 120 may be coupled to a first device (shown in FIG. 2 below) at the first surface 104, e.g., through the first contact pad 112 and the second contact pad 122. The first terminal of the third interconnect 130 may be coupled to the first device, e.g., through the third contact pad 132. The second terminal of the first interconnect 110 and the second terminal of the second interconnect 120 may be coupled to a first component (shown in FIG. 2 below) at the first surface 104, e.g., through the subsequent first and the subsequent second contact pads 116, 126 and/or the metal traces 142, 144. The second terminal of the third interconnect 130 may be coupled to the first component, e.g., through the subsequent third contact pad 134 and/or the third metal trace 146.

In an aspect, examples of the first device may include but are not limited to a central processing unit (CPU) device, a system-on-chip (SOC) device, a graphic processing unit (GPU) device, a field programmable gate array (FPGA) device, a deep learning processor (DLP) device, or a neural network processor (NNP) device. Examples of the first component may include but are not limited to a memory device, a voltage regulator or a decoupling capacitor, as illustrated in Fig. 2.

The present disclosure may provide an electronic package and/or board assembly with ground-coupled vertical interconnects for improved electrical performance and device miniaturization. According to various aspects, the third interconnect, e.g., a ground reference (Vss) interconnect, may be configured between the first interconnect and the second interconnect, and contact pads with recessed side may be configured for the first interconnect and the second interconnect to accommodate the third interconnect therebetween without increasing the pitch between the first interconnect and the second interconnect.

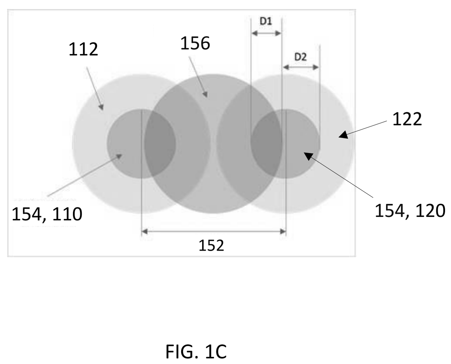

FIG. 1C illustrates design parameters of vertical interconnects in the top view according to the aspect shown in FIG. 1A to achieve robust manufacturability according to an aspect of the present disclosure.

In the aspect as shown in FIG. 1C, the first interconnect 110 and the second interconnect 120 may be provided or filled in primary drills 154 having a diameter d. The distance between the centers of the first interconnect 110 and the second interconnect 120 may be defined as the pitch 152. The first contact pad 112 and the second contact pad 122 may be respectively provided on the first interconnect 110 and the second interconnect 120, and may be separated by a secondary drill 156 having a diameter D to provide or form the first and the second recessed sides 114, 124 in the first and the second contact pads 112, 122. The third interconnect 130 and the dielectric layer 140 shown in FIG. 1A may be provided in the secondary drill 156. *D1* represents the overlapped distance between the primary drill 154 and the secondary drill 156. *D2* represents the distance between the hole wall of the primary drill 154 and the hole wall of the secondary drill 156, in other words, the distance between the side wall of the dielectric layer 140 and the side wall of the first interconnect 110 or the second interconnect 120.

A set of design-of-experiment (DOE) has been conducted based on the pitch 152, the primary drill diameter (d), and the secondary drill diameter (D) as shown in Table 1. Table 1 summarizes design rules (DRs) based on the overall DOE results. As observed in the DOE results, the interconnect structure according to various aspects may be designed with *D2* of equal to or more than 0.1mm in order to avoid structural failure. The interconnect structure according to various aspects may be designed with *D1* of equal to or more than 0.1mm to achieve the integrity of recessed or voiding post-secondary drill process without short circuit.

**Table 1**

| Design Rules | |
|---|---|
| Primary drill diameter, d (mm) | 0.2 |
| Secondary drill diameter, D (mm) | ≤0.4 |
| Minimum pitch (mm) | 0.4 |
| Overlapped distance between primary and secondary drills, D1 (mm) | ≥ 0.1 |
| Distance between the hole walls of primary and secondary drills, D2 (mm) | ≥ 0.1 |

FIG. 2 shows a cross-sectional view of a cross-sectional view of an electronic assembly 200 according to a further aspect of the present disclosure.

Many of the aspects of the electronic assembly 200 are the same or similar to those of the electronic assembly 100. For the sake of brevity, duplicate descriptions of features and properties are omitted. Accordingly, it will be understood that the descriptions of any feature and/or property relating to FIG. 2 that are the same or similar to a feature and/or property in FIGS. 1A to 1C will have those descriptions be applicable herein below as well.

In the aspect shown in FIG. 2, an electronic assembly 200 of the present disclosure is shown in a cross-sectional view layout. Similar to the electronic assembly 100, the electronic assembly 200 may include a substrate 202 having a first surface 204 and a second surface 206 opposite the first surface 204. The substrate 202 may include a printed circuit board, or may include one of a silicon substrate, a glass substrate, an organic substrate or a ceramic substrate. The electronic assembly 200 may include a first interconnect 210 and a second interconnect 220 in the substrate 202 extending perpendicular to the first surface 204 and the second surface 206. The electronic assembly 200 may include a third interconnect 230 arranged between the first interconnect 210 and the second interconnect 220. The electronic assembly 200 may include a first contact pad (not shown) having a first recessed side and coupled to a first terminal of the first interconnect, and may include a subsequent first contact pad 216 having a subsequent first recessed side and coupled to an opposing second terminal of the first interconnect 210. The electronic assembly 200 may include a second contact pad (not shown) having a second recessed side and coupled to a first terminal of the second interconnect, and may include a subsequent second contact pad 226 having a subsequent second recessed side and coupled to an opposing second terminal of the second interconnect 220.

Similar to FIGS. 1A to 1C, the third interconnect 230 may extend in parallel with the first interconnect 210 and the second interconnect 220. In other words, each of the interconnects 210, 220, 230 may extend perpendicular to the first surface 204 and the second surface 206 to form a respective vertical interconnect, for example, a PTH.

Similar to FIGS. 1A to 1C, the first contact pad and the second contact pad may be arranged on the first surface 204 of the substrate 202. In various aspects, the recessed side of the first contact pad and the recessed side of the second contact pad may each include a receding portion having a cross section in a crescent and/or gibbous shape, e.g., as shown in FIG. 1A. Other shapes may also be possible.

Similar to FIGS. 1A to 1C, the subsequent first contact pad 216 and the subsequent second contact pad 226 may be arranged under the second surface 206 of the substrate 202. In various aspects, the subsequent recessed side of the subsequent first contact pad 216 and the subsequent recessed side of the subsequent second contact pad 226 may each include a receding portion having a cross section in a crescent and/or gibbous shape. Other shapes may also be possible.

In various aspects, the electronic assembly 200 may further include a third contact pad (not shown) coupled to a first terminal of the third interconnect 230 at the first surface 204, and a subsequent third contact pad 234 coupled to an opposing second terminal of the third interconnect 230 at the second surface 206. In an aspect, the third contact pad may be arranged on the first surface 204, and the subsequent third contact pad 234 may be arranged under the second surface 206.

The third contact pad may be at least partially encircled by the first recessed side and the second recessed side. The subsequent third contact pad 234 may be at least partially encircled by the subsequent first recessed side and the subsequent second recessed side. The third contact pad and the subsequent third contact pad 234 may have a circular shape, or any other suitable shape.

In an aspect, the third interconnect 230 may have a height or depth same with the first interconnect 210 and the second interconnect 220, as shown in FIG. 2 and FIG. 4G below. In another aspect, the third interconnect 230 may have a height or depth larger than the first interconnect 210 and the second interconnect 220, similar to the aspect shown in FIG. 1B.

In various aspects, the third interconnect 230 may be isolated from the first interconnect 210 and the second interconnect 220 by a dielectric layer.

The distance between the centers of the first interconnect 210 and the second interconnect 220 may be defined as a pitch. Based on the various aspects of the present disclosure, the third interconnect 230 may be additionally provided within the pitch dimension of the first interconnect 210 and the second interconnect 220, as compared to conventional structures wherein two interconnects may be provided in the same pitch dimension required according to the design rules.

Similar to FIGS. 1A to 1C, the first interconnect 210 may include a first side wall having a height extending between the first surface 204 and second surface 206, and the second interconnect 220 may include a second side wall having a height extending between the first surface 204 and second surface 206. In an aspect, the first side wall and the second side wall may each include a recessed portion that may extend between the first surface 204 and second surface 206 to form a first recessed side wall and a second recessed side wall, respectively. The first recessed side wall and the second recessed side wall may have a crescent-shaped cross section similar to the aspect shown in FIG. 1A. The first recessed side of the first contact pad and the subsequent first recessed side of the subsequent first contact pad 216 may be aligned with the first recessed side wall of the first interconnect 210. The second recessed side of the second contact pad and the subsequent second recessed side of the subsequent second contact pad 226 may be aligned with the second recessed side wall of the second interconnect 220. In another aspect, the first side wall and the second side wall may be integral without a recessed portion, similar to a side wall of a cylinder as shown in FIG. 5B below.

In various aspects, the third interconnect 230 may extend in parallel with and may be at least partially encircled by the first recessed side wall and the second recessed side wall. In various aspects, the first recessed side wall and the second recessed side wall may face the third interconnect 230.

In an aspect, the first interconnect 210, the second interconnect 220 and the third interconnect 230 may be configured to facilitate electrical signal transmission.

In one aspect, the first interconnect 210 and the second interconnect 220 may be configured to transmit a single-ended bus signal, e.g., a low-power double data-rate (LPDDR) memory interface at 8533 MT/s or beyond. In another aspect, the first interconnect 210 and the second interconnect 220 may be configured to transmit a differential-pair bus signal, e.g., a universal serial bus Gen4 (USB4.0) interface operating at ≥20Gbps, a Thunderbolt^{™} 5th Generation (TBT 5) interface with operating data-rate ranging from 80 to 120 Gbps, a peripheral component interconnect express Gen6 PCIe6 (64 Gbps), or a serial-de-serializer (Serdes) ethernet interface operating at ≥112Gbps. The third interconnect 230 may be coupled to a reference voltage, e.g., a ground (Vss) reference voltage, for noise shielding through a shorter current return path.

In a further aspect, the first interconnect 210, the second interconnect 220 and the third interconnect 230 may be configured to facilitate power delivery. In an aspect, the first interconnect 210 and the second interconnect 220 may be configured with a voltage supply, e.g., a 1.0 V supply. In another aspect, the first interconnect 210 may be configured with a first voltage supply, e.g., a 1.0V supply, and the second interconnect 220 may be configured with a second voltage supply different from the first voltage supply, e.g., a 1.5V supply. The third interconnect 230 may be configured to a reference voltage, such as a ground (Vss) reference voltage for improved power integrity through a reduced AC inductance loop.

In various aspects, the electronic assembly 200 may optionally include one or more first metal traces and/or planes 242 coupled to the first interconnect 210 and/or one or more of the first and the subsequent first contact pads. In further aspects, the electronic assembly 200 may optionally include one or more second metal traces and/or planes 244 coupled to the second interconnect 220 and/or one or more of the second and the subsequent second contact pads. In further aspects, the electronic assembly 200 may optionally include one or more third metal traces and/or planes 246 coupled to the third interconnect 230 and/or one or more of the third and the subsequent third contact pads. In various aspects, each of the first metal traces, the second metal traces and the third metal traces may be arranged on the first surface 204 or the second surface 206, or may be embedded within the substrate 202.

In an aspect as shown in FIG. 2, a first metal trace and/or plane 242 may be arranged on the second surface 206, and may be coupled to the subsequent first contact pad 216 at the second surface 206, thus being indirectly coupled to the first interconnect 210. A second metal trace and/or plane 244 may be embedded within the substrate 202, and may be coupled to a body of the second interconnect 220. A third metal trace and/or plane 246 may be embedded within the substrate 202, and may be coupled to a body of the third interconnect 230.

In various aspects of FIG. 2, the electronic assembly 200 may further include a first device 262 at the first surface 204, which may be coupled to the first terminal of the first interconnect 210 and the first terminal of the second interconnect 220. The first device 262 may be further coupled to the first terminal of the third interconnect 230. In an aspect of FIG. 2, the first device 262 may be coupled to the interconnects 210, 220, 230 through solder bumps and contact pads, wherein there is direct vertical alignment from the first device 262 to the interconnects 210, 220, 230. In another aspect, the metal traces for coupling with the contact pads of the interconnects 210, 220, 230 may be included for signal/power breakouts when there is no direct vertical alignment from the first device to the interconnects 210, 220, 230.

In an aspect, examples of the first device 262 may include but are not limited to a central processing unit (CPU) device, a system-on-chip (SOC) device, a graphic processing unit (GPU) device, a field programmable gate array (FPGA) device, a deep learning processor (DLP) device, or a neural network processor (NNP) device.

In various aspects of FIG. 2, the electronic assembly 200 may further include a first component 264 at the first surface 204, which may be coupled to the second terminal of the first interconnect 210, the second terminal of the second interconnect 220 and the second terminal of the third interconnect 230. In an aspect of FIG. 2, the first component 264 may be coupled to the first interconnect 210 and the second interconnect 220 through one or more of the subsequent first and the subsequent second contact pads 216, 226 and the metal traces 242, 244, wherein there is no direct vertical alignment from the first component 264 to the interconnects 210, 220. The first component 264 may be coupled to the third interconnect 230 through one or more of the subsequent third contact pad 234 and the third metal traces 246.

In an aspect, examples of the first component 264 may include but are not limited to a memory device, a voltage regulator or a decoupling capacitor.

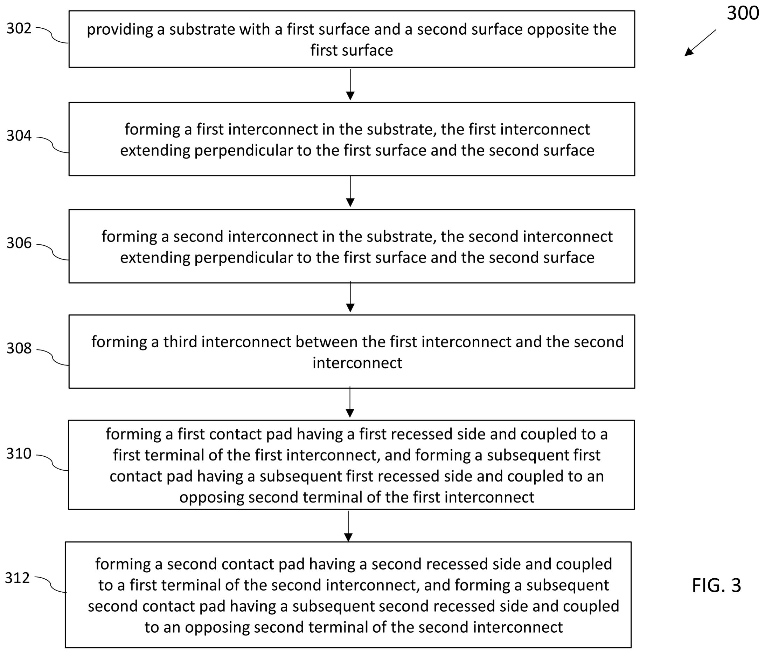

FIG. 3 shows a flowchart 300 illustrating a method of forming an electronic assembly, such as the electronic assembly 100, 200 of FIGS. 1A-1C and 2, according to an aspect of the present disclosure. Various aspects described with reference to FIGS. 1A-1C and 2 may be similarly applied for the method of FIG. 3.

At 302, the method may include providing a substrate with a first surface and a second surface opposite the first surface.

At 304, the method may include forming a first interconnect in the substrate, the first interconnect extending perpendicular to the first surface and the second surface.

At 306, the method may include forming a second interconnect in the substrate, the second interconnect extending perpendicular to the first surface and the second surface.

At 308, the method may include forming a third interconnect between the first interconnect and the second interconnect.

At 310, the method may include forming a first contact pad having a first recessed side and coupled to a first terminal of the first interconnect, and forming a subsequent first contact pad having a subsequent first recessed side and coupled to an opposing second terminal of the first interconnect.

At 312, the method may include forming a second contact pad having a second recessed side and coupled to a first terminal of the second interconnect, and forming a subsequent second contact pad having a subsequent second recessed side and coupled to an opposing second terminal of the second interconnect.

It will be understood that the operations described above relating to FIG. 3 are not limited to this particular order. Any suitable, modified order of operations may be used.

FIGS. 4A through 4H show cross-sectional and top views directed to an exemplary process flow for a method of forming an electronic assembly (e.g., the electronic assembly 100, 200) according to an aspect of the present disclosure. The order of assembly process operation may be interchangeable. Various aspects described with reference to FIGS. 1A-1C, 2 and 3 may be similarly applied for the process flow of FIG. 4A-4H.

FIG. 4A shows a cross-sectional view (left) and a top view (right) of a substrate 402 having a first surface 404 and a second surface 406 opposite the first surface 404. Primary openings 407, including a first opening and a second opening, may be formed in the substrate 402, e.g., through a mechanical/laser drilling process. The first opening and the second opening may extend through the substrate 402 between the first surface 404 and the second surface 406. The substrate 402 may include a silicon substrate, a glass substrate, an organic substrate, or a ceramic substrate.

FIG. 4B shows a cross-sectional view (left) and a top view (right) of a first interconnect 410 and a second interconnect 420 arranged adjacent each other in the substrate 402. The first interconnect 410 and the second interconnect 420 may be formed in the first opening and the second opening, e.g., through an electroplating or solder printing process. The first interconnect 410 and the second interconnect 420 may extend perpendicular to the first surface 404 and the second surface 406.

FIG. 4C shows a cross-sectional view (left) and a top view (right) of a secondary opening 408 formed in the substrate 402, e.g., through a mechanical/laser drilling process. The secondary opening 408 may be formed between the first interconnect 410 and the second interconnect 420. The secondary opening 408 may protrude into the first interconnect 410 and the second interconnect 420, to form a recessed side wall in the first interconnect 410 and a recessed side wall in the second interconnect 420 in the aspect as shown in FIG. 4C.

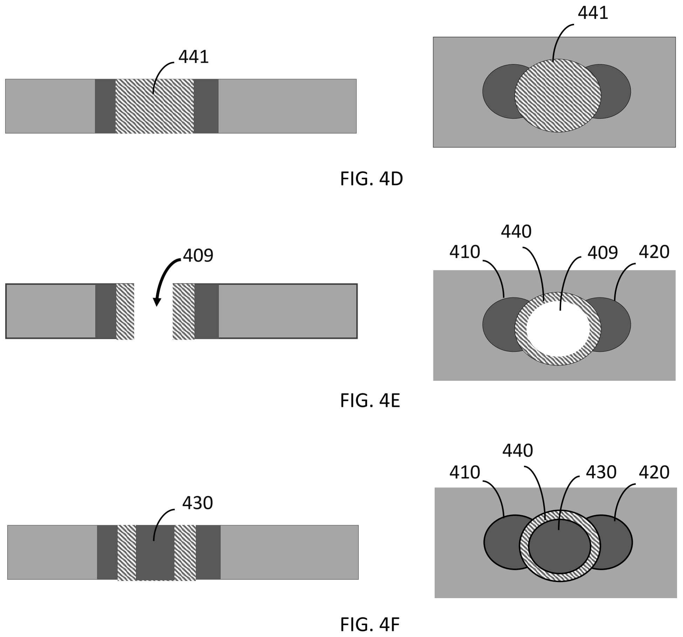

FIG. 4D shows a cross-sectional view (left) and a top view (right) of an initial dielectric or insulating layer 441 formed in the substrate 402. The secondary opening 408 may be filled with the initial dielectric layer 441, e.g., through a printing, coating, dispense, or plugging process.

FIG. 4E shows a cross-sectional view (left) and a top view (right) of a dielectric opening 409 formed in the initial dielectric layer 441, e.g., through a mechanical/laser drilling process. The dielectric opening 409 may remove a central portion of the initial dielectric layer 441, to form a dielectric layer 440 in contact with the first interconnect 410 and the second interconnect 420.

FIG. 4F shows a cross-sectional view (left) and a top view (right) of a third interconnect 430 formed in the dielectric opening 409, e.g., through an electroplating or solder printing process. The third interconnect 430 may extend in parallel with the first and the second interconnects 410, 420, and may be separated from the first and the second interconnects 410, 420 by the dielectric layer 440.

FIG. 4G shows a cross-sectional view (left) and a top view (right) of contact pads formed on the first surface 404 and the second surface 406, e.g., through electroplating and etching process. The contact pads may include the first contact pad 412, the second contact pad 422, and the third contact pad 432 formed on the first terminals of the first, the second and the third interconnects 410, 420, 430, respectively. The contact pads may further include the subsequent first contact pad 416, the subsequent second contact pad 426, and the subsequent third contact pad 434 formed on the opposing second terminals of the first, the second and the third interconnects 410, 420, 430, respectively. The contact pads 412, 422, 416, 426 coupled to the first and the second interconnects 410, 420 may each include a recessed side, and may be in a crescent or gibbous shape in the aspect shown in FIG. 4G. The contact pads 432, 434 coupled to the third interconnect 430 may be integral without a recessed side, for example, in a circular shape.

FIG. 4H shows a cross-sectional view of top and bottom build up layers 470 formed on the first surface 404 and the second surface 406, e.g., through electroplating and etching process.

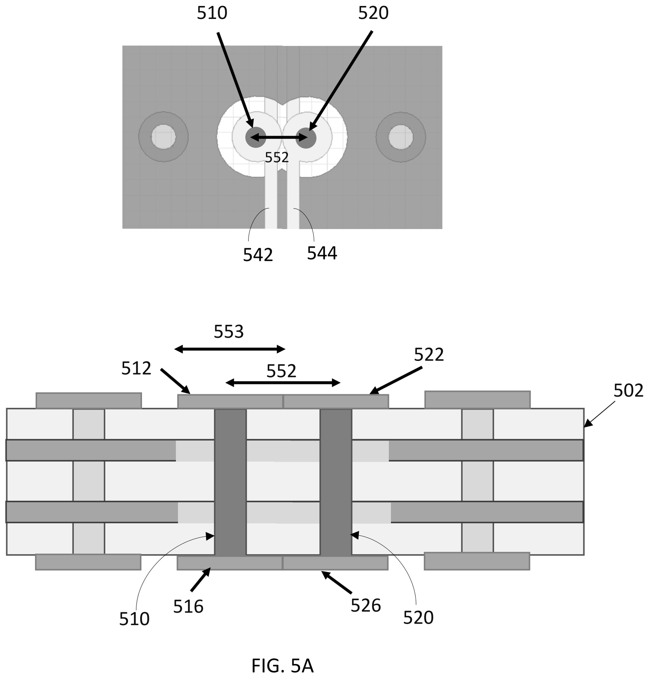

FIGS. 5A through 5F show top and cross-sectional views directed to an exemplary process flow for a method of forming an electronic assembly (e.g., the electronic assembly 100, 200) according to an aspect of the present disclosure. The order of assembly process operation may be interchangeable. Various aspects described with reference to FIGS. 1A-1C, 2, 3 and 4A-4H may be similarly applied for the process flow of FIGS. 5A-5F.

FIG. 5A shows a top view (top) and a cross-sectional view (bottom) of a first interconnect 510 and a second interconnect 520 arranged adjacent each other in a substrate 502 (e.g., a printed circuit board 502 including alternating metal layers and dielectric layers). The first interconnect 510 and the second interconnect 520 may be formed, e.g., through mechanical/laser drilling and electroplating process.

The first interconnect 510 may include a first contact pad 512 and a subsequent first contact pad 516 coupled thereto as described in earlier paragraphs. Similarly, the second interconnect 520 may include a second contact pad 522 and a subsequent second contact pad 526 coupled thereto. A plurality of metal traces and/or planes 542, 544 may be optionally included and coupled to the respective contact pads 512, 516, 522, 526.

As shown in FIG. 5A, a pitch 552 between the first interconnect 510 and the second interconnect 520 may be smaller than that between interconnects of a conventional setup by arranging the presently disclosed contact pads as closely as possible. In further aspects, the first and second contact pads 512, 522 may be arranged to contact each other, or may be arranged to at least partially overlap with each other, for further pitch reduction.

In an aspect, the electronic assembly may be formed wherein the pitch 552 may be larger than the diameter 553 of the contact pads 512, 522, 516, 526 for better manufacturability. In another aspect, the electronic assembly may be formed wherein the pitch 552 may be equal to or less than the diameter 553 of the contact pads 512, 522, 516, 526 for further pitch reduction. According to various aspects, a ratio between the pitch 552 and the contact pad diameter 553 may be in a range from 0.7 to 1.3. In a further example, the ratio between the pitch 552 and the contact pad diameter 553 may be in a range from 0.8 to 1.2.

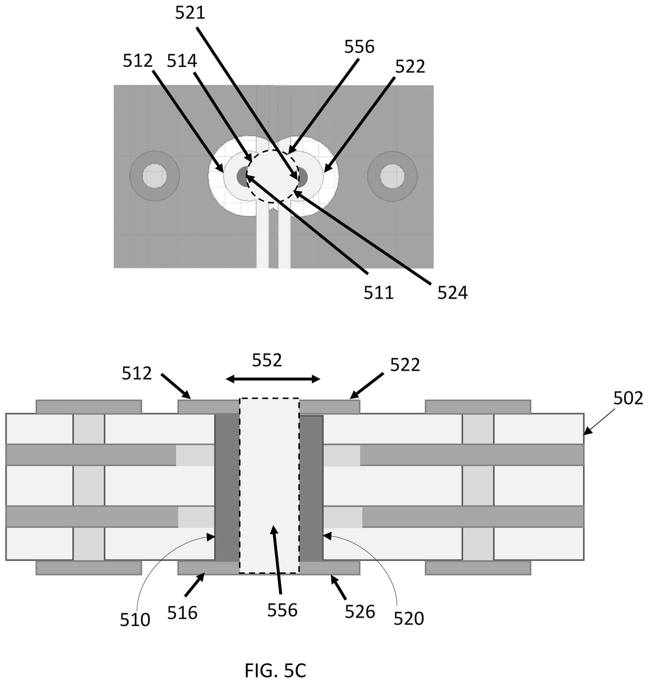

FIG. 5B shows a top view (top) and a cross-sectional view (bottom) of a substrate opening 556 formed in the substrate 502 according to an aspect, and FIG. 5C shows a top view (top) and a cross-sectional view (bottom) of a substrate opening 556 formed in the substrate 502 according to another aspect.

The substrate opening 556 may be a drilled through hole, similar to the secondary drill 156 shown in FIG. 1C, and may be formed, e.g., through a mechanical/laser drilling process. By forming the substrate opening 556, portions of the first, the subsequent first, the second, and the subsequent second contact pads 512, 516, 522, 526 may be removed to form a respective recessed side for the respective contact pad. In the aspect shown in the top view of FIG. 5B, the first contact pad 512 may be formed with a first recessed side 514, and the second contact pad 522 may be formed with a second recessed side 524.

In the aspect of FIG. 5B, the substrate opening 556 may be formed with a diameter smaller than a minimum spacing between the first interconnect 510 and the second interconnect 520. In other words, the substrate opening 556 may form the recessed sides on the contact pads, without encroaching the first interconnect 510 and the second interconnect 520. Thus, the first interconnect 510 and the second interconnect 520 may have a circular-shaped cross section, without a recessed side wall.

In another aspect (not shown), the substrate opening 556 may be formed with a diameter equal to the minimum spacing between the first interconnect 510 and the second interconnect 520. In other words, the substrate opening 556 may form the recessed sides on the contact pads, without encroaching the first interconnect 510 and the second interconnect 520. Thus, the first interconnect 510 and the second interconnect 520 may have a circular-shaped cross section, without a recessed side wall.

In a further aspect as shown in FIG. 5C, the substrate opening 556 may be formed with a diameter larger than the minimum spacing between the first interconnect 510 and the second interconnect 520. In other words, the substrate opening 556 may both form the recessed sides on the contact pads and form recessed side walls on the interconnects.

As shown in FIG. 5C, the substrate opening 556 may encroach the first interconnect 510 to form a first recessed side wall 511, and may encroach the second interconnect 520 to form a second recessed side wall 521. The first recessed side wall 511 of the first interconnect 510 and the second recessed side wall 521 of the second interconnect 520 may have a crescent-shaped cross section, for example.

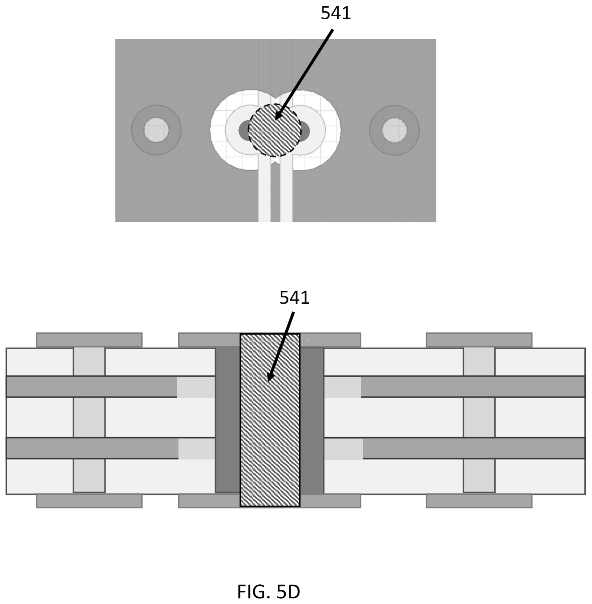

FIG. 5D shows a top view (top) and a cross-sectional view (bottom) of an initial dielectric or insulating layer 541 formed in the substrate opening 556, e.g., through a printing, a coating, a dispensing, or a plugging process.

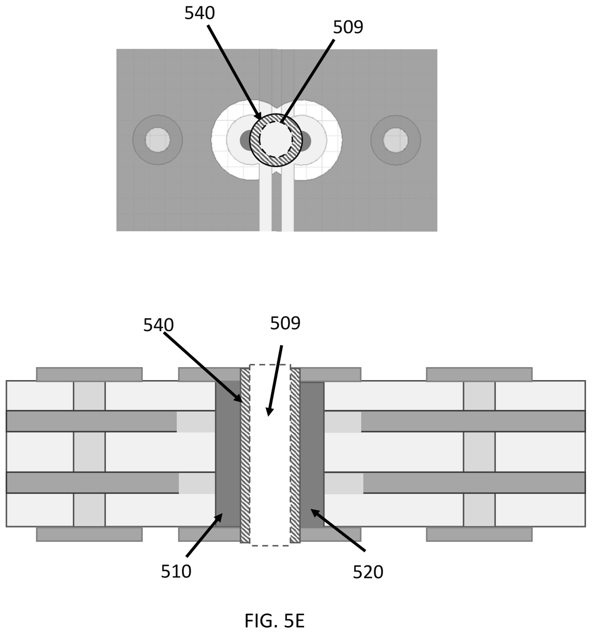

FIG. 5E shows a top view (top) and a cross-sectional view (bottom) of a dielectric opening 509 formed in the initial dielectric layer 541, e.g., through a mechanical/laser drilling process. The dielectric opening 509 may remove a central portion of the initial dielectric layer 541, to form a dielectric layer 540 in contact with the first and the second interconnects 510, 520.

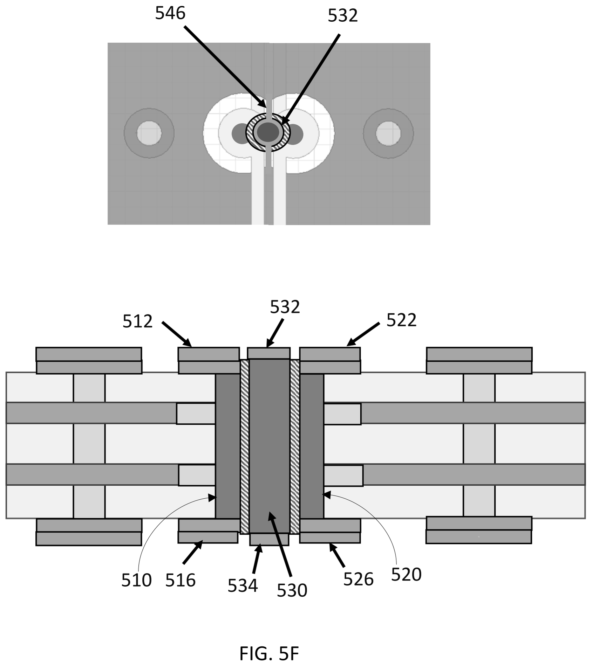

FIG. 5F shows a top view (top) and a cross-sectional view (bottom) of a third interconnect 530 formed in the dielectric opening 509, e.g., through an electroplating or solder printing process. A third contact pad 532 may be formed on the top surface of the substrate 502, and may be coupled to the first terminal of the third interconnect 530. A subsequent third contact pad 534 may be formed under the bottom surface of the substrate 502, and may be coupled to the second terminal of the third interconnect 530. One or more third metal traces and/or planes 546 (e.g., coupled to a ground reference voltage) may be coupled to one or more of the third and the subsequent third contact pads 532, 534.

Additional layers of the first contact pad 512, the second contact pad 522, the subsequent first contact pad 516, and the subsequent second contact pad 526 may be formed in the process of forming the third contact pad 532 and the subsequent third contact pad 534, such that these contact pads may be coplanar with the third contact pad 532 and the subsequent third contact pad 534 in the structure of FIG. 5F. As shown in the aspect of FIG. 5F, the first contact pad 512, the second contact pad 522, the subsequent first contact pad 516, and the subsequent second contact pad 526 may have a thickness larger than a thickness of the third contact pad 532 and the subsequent third contact pad 534. The third interconnect 530 may have a height larger than a height of the first and the second interconnects 510, 520.

The contact pads 512, 522, 516, 526 coupled to the first and the second interconnects 510, 520 may each include a recessed side, and may be in a crescent or gibbous shape in the aspect shown in FIG. 5F. The contact pads 532, 534 coupled to the third interconnect 530 may be integral without a recessed side, for example, in a circular shape.

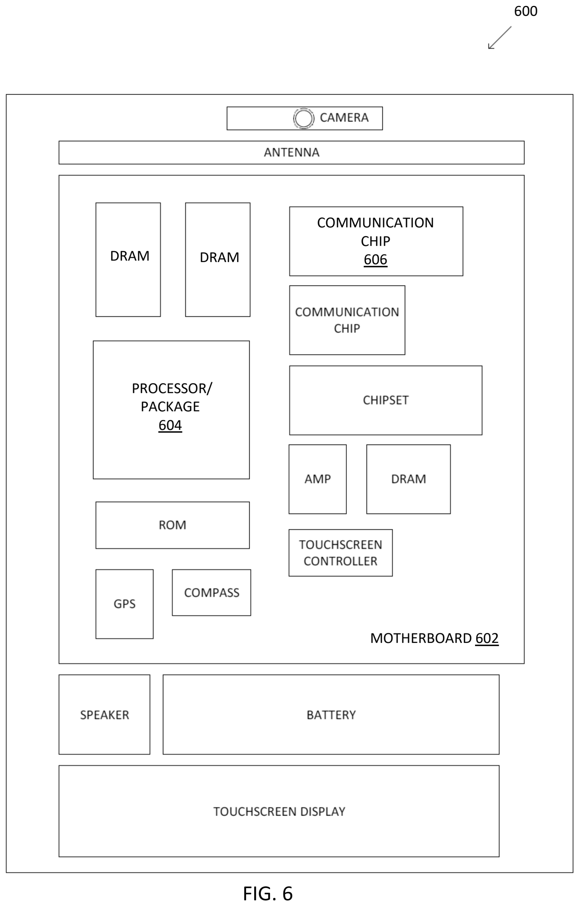

Aspects of the present disclosure may be implemented into a system using any suitable hardware and/or software. FIG. 6 schematically illustrates a computing device 600 that may include an electronic assembly 100, 200 as described herein, in accordance with some aspects. The computing device 600 may house a board such as a motherboard 602. The motherboard 602 may include several components, including but not limited to a processor 604, according to the present disclosure, and at least one communication chip 606. The processor 604, which may have an electronic assembly according to the present disclosure, may be physically and electrically coupled to the motherboard 602. In some implementations, the at least one communication chip 606 may also be physically and electrically coupled to the motherboard 602. In further implementations, the communication chip 606 may be part of the processor 604.

Depending on its applications, the computing device 600 may include other components that may or may not be physically and electrically coupled to the motherboard 602. These other components may include, but are not limited to, volatile memory (e.g., DRAM), nonvolatile memory (e.g., ROM), flash memory, a graphics processor, a digital signal processor, a cryptoprocessor, a chipset, an antenna, a display, a touchscreen display, a touchscreen controller, a battery, an audio codec, a video codec, a power amplifier, a global positioning system (GPS) device, a compass, a Geiger counter, an accelerometer, a gyroscope, a speaker, a camera, and a mass storage device (such as hard disk drive, compact disk (CD), digital versatile disk (DVD), and so forth).

The communication chip 606 may enable wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some aspects they might not. The communication chip 606 may implement any of several wireless standards or protocols, including but not limited to Institute for Electrical and Electronics Engineers (IEEE) standards including Wi-Fi (IEEE 502.11 family), IEEE 502.16 standards (e.g., IEEE 502.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 502.16 compatible BWA networks are generally referred to as WiMAX networks, an acronym that stands for Worldwide Interoperability for Microwave Access, which is a certification mark for products that pass conformity and interoperability tests for the IEEE 502.16 standards.

The communication chip 606 may also operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 606 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 606 may operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond. The communication chip 606 may operate in accordance with other wireless protocols in other aspects.

The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

In various implementations, the computing device 600 may be a laptop, a netbook, a notebook, an ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In an aspect, the computing device 600 may be a mobile computing device. In further implementations, the computing device 600 may be any other electronic device that processes data.

### Examples

Example 1 may include an electronic assembly including a substrate having a first surface and a second surface opposite the first surface; a first interconnect in the substrate extending perpendicular to the first surface and the second surface; a second interconnect in the substrate extending perpendicular to the first surface and the second surface; a third interconnect arranged between the first interconnect and the second interconnect; a first contact pad having a first recessed side and coupled to a first terminal of the first interconnect; a subsequent first contact pad having a subsequent first recessed side and coupled to an opposing second terminal of the first interconnect; a second contact pad having a second recessed side and coupled to a first terminal of the second interconnect, and a subsequent second contact pad having a subsequent second recessed side and coupled to an opposing second terminal of the second interconnect.

Example 2 may include the subject matter of Example 1, further including a third contact pad coupled to a first terminal of the third interconnect, and a subsequent third contact pad coupled to an opposing second terminal of the third interconnect. The third contact pad may be at least partially encircled by the first recessed side and the second recessed side, and the subsequent third contact pad may be at least partially encircled by the subsequent first recessed side and the subsequent second recessed side.

Example 3 may include the subject matter of Example 1 or 2, wherein the third interconnect may extend in parallel with the first interconnect and the second interconnect, and may be isolated from the first interconnect and the second interconnect by a dielectric layer.

Example 4 may include the subject matter of any one of Example 1 to 3, wherein the first interconnect may include a first recessed side wall, and the second interconnect may include a second recessed side wall.

Example 5 may include the subject matter of Example 4, wherein the third interconnect may extend in parallel with and may be at least partially encircled by the first recessed side wall and the second recessed side wall.

Example 6 may include the subject matter of Example 4 or 5, wherein the first recessed side wall and the second recessed side wall may face the third interconnect.

Example 7 may include the subject matter of any one of Example 4 to 6, wherein the first recessed side and the subsequent first recessed side may be aligned with the first recessed side wall, and wherein the second recessed side and the subsequent second recessed side may be aligned with the second recessed side wall.

Example 8 may include the subject matter of any one of Example 1 to 7, wherein the third interconnect may be coupled to a reference voltage.

Example 9 may include the subject matter of any one of Example 1 to 8, wherein the first interconnect and the second interconnect may be configured with a single-ended electrical signal or a differential pair electrical signal.

Example 10 may include the subject matter of any one of Example 1 to 9, wherein the first interconnect and the second interconnect may be configured with a voltage supply.

Example 11 may include the subject matter of any one of Example 1 to 10, wherein the first interconnect may be configured with a first voltage supply, and the second interconnect may be configured with a second voltage supply different from the first voltage supply.

Example 12 may include the subject matter of any one of Example 1 to 11, wherein the first terminal of the first interconnect and the first terminal of the second interconnect may be coupled to a first device at the first surface, and wherein the opposing second terminal of the first interconnect and the opposing second terminal of the second interconnect may be coupled to a first component at the first surface.

Example 13 may include the subject matter of Example 12, wherein the first device may include a central processing unit device, a system-on-chip device, a graphic processing unit device, a field programmable gate array device, a deep learning processor device, or a neural network processor device.

Example 14 may include the subject matter of Example 12 or 13, wherein the first component may include a memory device, a voltage regulator, or a decoupling capacitor.

Example 15 may include a computing device including a printed circuit board and an electronic assembly coupled to the printed circuit board. The electronic assembly may include a substrate having a first surface and a second surface opposite the first surface; a first interconnect in the substrate extending perpendicular to the first surface and the second surface; a second interconnect in the substrate extending perpendicular to the first surface and the second surface; a third interconnect arranged between the first interconnect and the second interconnect; a first contact pad having a first recessed side and coupled to a first terminal of the first interconnect; a subsequent first contact pad having a subsequent first recessed side and coupled to an opposing second terminal of the first interconnect; a second contact pad having a second recessed side and coupled to a first terminal of the second interconnect; and a subsequent second contact pad having a subsequent second recessed side and coupled to an opposing second terminal of the second interconnect.

Example 16 may include the subject matter of Example 15, further including a third contact pad coupled to a first terminal of the third interconnect, and a subsequent third contact pad coupled to an opposing second terminal of the third interconnect; wherein the third contact pad may be at least partially encircled by the first recessed side and the second recessed side; and wherein the subsequent third contact pad may be at least partially encircled by the subsequent first recessed side and the subsequent second recessed side.

Example 17 may include the subject matter of Example 15 or 16, wherein the first interconnect may include a first recessed side wall, and the second interconnect may include a second recessed side wall.

Example 18 may include a method of forming an electronic assembly. The method may include providing a substrate with a first surface and a second surface opposite the first surface; forming a first interconnect in the substrate, the first interconnect extending perpendicular to the first surface and the second surface; forming a second interconnect in the substrate, the second interconnect extending perpendicular to the first surface and the second surface; and forming a third interconnect between the first interconnect and the second interconnect. The method may further include forming a first contact pad having a first recessed side and coupled to a first terminal of the first interconnect, and forming a subsequent first contact pad having a subsequent first recessed side and coupled to an opposing second terminal of the first interconnect. The method may further include forming a second contact pad having a second recessed side and coupled to a first terminal of the second interconnect, and forming a subsequent second contact pad having a subsequent second recessed side and coupled to an opposing second terminal of the second interconnect.

Example 19 may include the subject matter of Example 18, further including coupling a third contact pad to a first terminal of the third interconnect, wherein the third contact pad may be at least partially encircled by the first recessed side and the second recessed side; and coupling a subsequent third contact pad to an opposing second terminal of the third interconnect; wherein the subsequent third contact pad may be at least partially encircled by the subsequent first recessed side and the subsequent second recessed side.

Example 20 may include the subject matter of Example 18 or 19, further including forming a first recessed side wall in the first interconnect; and forming a second recessed side wall in the second interconnect.

In a further example, any one or more of examples 1 to 20 may be combined.

These and other advantages and features of the aspects herein disclosed will be apparent through reference to the above description and the accompanying drawings. Furthermore, it is to be understood that the features of the various aspects described herein are not mutually exclusive and can exist in various combinations and permutations.

It will be understood that any property described herein for a specific device may also hold for any device described herein. It will also be understood that any property described herein for a specific method may hold for any of the methods described herein. Furthermore, it will be understood that for any device or method described herein, not necessarily all the components or operations described will be enclosed in the device or method, but only some (but not all) components or operations may be enclosed.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words, coupling without direct contact) may be provided.

While the present disclosure has been particularly shown and described with reference to specific aspects, it should be understood by those skilled in the art that various changes in form and detail may be made therein without departing from the scope of the present disclosure as defined by the appended claims. The scope of the present disclosure is thus indicated by the appended claims and all changes which come within the meaning and range of equivalency of the claims are therefore intended to be embraced.

## Claims

1. An electronic assembly comprising:
a substrate having a first surface and a second surface opposite the first surface;
a first interconnect in the substrate extending perpendicular to the first surface and the second surface;
a second interconnect in the substrate extending perpendicular to the first surface and the second surface;
a third interconnect arranged between the first interconnect and the second interconnect;
a first contact pad comprising a first recessed side and coupled to a first terminal of the first interconnect, and a subsequent first contact pad comprising a subsequent first recessed side and coupled to an opposing second terminal of the first interconnect; and
a second contact pad comprising a second recessed side and coupled to a first terminal of the second interconnect, and a subsequent second contact pad comprising a subsequent second recessed side and coupled to an opposing second terminal of the second interconnect.

2. The electronic assembly of claim 1, further comprising:
a third contact pad coupled to a first terminal of the third interconnect, and a subsequent third contact pad coupled to an opposing second terminal of the third interconnect; wherein the third contact pad is at least partially encircled by the first recessed side and the second recessed side; and wherein the subsequent third contact pad is at least partially encircled by the subsequent first recessed side and the subsequent second recessed side.

3. The electronic assembly of any one of claims 1 or 2,
wherein the third interconnect extends in parallel with the first interconnect and the second interconnect, and is isolated from the first interconnect and the second interconnect by a dielectric layer.

4. The electronic assembly of any one of claims 1 to 3,
wherein the first interconnect comprises a first recessed side wall, and the second interconnect comprises a second recessed side wall;
preferably wherein the third interconnect extends in parallel with and is at least partially encircled by the first recessed side wall and the second recessed side wall; or
preferably wherein the first recessed side wall and the second recessed side wall face the third interconnect.

5. The electronic assembly of claim 4,
wherein the first recessed side and the subsequent first recessed side are aligned with the first recessed side wall, and wherein the second recessed side and the subsequent second recessed side are aligned with the second recessed side wall.

6. The electronic assembly of any one of claims 1 to 5,
wherein the third interconnect is coupled to a reference voltage.

7. The electronic assembly of any one of claims 1 to 6,
wherein the first interconnect and the second interconnect are configured with a single-ended electrical signal or a differential pair electrical signal.

8. The electronic assembly of any one of claims 1 to 7,
wherein the first interconnect and the second interconnect are configured with a voltage supply.

9. The electronic assembly of any one of claims 1 to 8,
wherein the first interconnect is configured with a first voltage supply, and the second interconnect is configured with a second voltage supply different from the first voltage supply.

10. The electronic assembly of any one of claims 1 to 9,
wherein the first terminal of the first interconnect and the first terminal of the second interconnect are coupled to a first device at the first surface, and wherein the opposing second terminal of the first interconnect and the opposing second terminal of the second interconnect are coupled to a first component at the first surface;
preferably wherein the first device comprises a central processing unit device, a system-on-chip device, a graphic processing unit device, a field programmable gate array device, a deep learning processor device, or a neural network processor device.

11. The electronic assembly of claim 10,
wherein the first component comprises a memory device, a voltage regulator, or a decoupling capacitor.

12. A computing device comprising:
a printed circuit board; and
an electronic assembly of any one of claims 1 to 11 coupled to the printed circuit board.

13. A method comprising:
providing a substrate with a first surface and a second surface opposite the first surface;
forming a first interconnect in the substrate, the first interconnect extending perpendicular to the first surface and the second surface;
forming a second interconnect in the substrate, the second interconnect extending perpendicular to the first surface and the second surface;
forming a third interconnect between the first interconnect and the second interconnect;
forming a first contact pad comprising a first recessed side and coupled to a first terminal of the first interconnect, and forming a subsequent first contact pad comprising a subsequent first recessed side and coupled to an opposing second terminal of the first interconnect; and
forming a second contact pad comprising a second recessed side and coupled to a first terminal of the second interconnect, and forming a subsequent second contact pad comprising a subsequent second recessed side and coupled to an opposing second terminal of the second interconnect.

14. The method of claim 13, further comprising:
coupling a third contact pad to a first terminal of the third interconnect, wherein the third contact pad is at least partially encircled by the first recessed side and the second recessed side; and
coupling a subsequent third contact pad to an opposing second terminal of the third interconnect, wherein the subsequent third contact pad is at least partially encircled by the subsequent first recessed side and the subsequent second recessed side.

15. The method of any one of claims 13 or 14, further comprising:
forming a first recessed side wall in the first interconnect; and
forming a second recessed side wall in the second interconnect.
